Europäisches Patentamt

European Patent Office

Office européen des brevets

(11) Numéro de publication: **0 193 045**
**B1**

# FASCICULE DE BREVET EUROPÉEN

(45) Date de publication du fascicule du brevet:
21.06.89

(21) Numéro de dépôt: 86101875.2

(22) Date de dépôt: 14.02.86

(51) Int. Cl.⁴: **G 04 C 10/00,** H 01 H 9/00

(54) **Module de montre électronique agencé pour adapter la polarité de la pile à celle du circuit.**

(30) Priorité: 22.02.85 CH 814/85

(43) Date de publication de la demande:
03.09.86 Bulletin 86/36

(45) Mention de la délivrance du brevet:
21.06.89 Bulletin 89/25

(84) Etats contractants désignés:
DE FR GB

(56) Documents cité:
EP-A-0 019 836
EP-A-0 024 364
DE-A-1 945 678
DE-A-2 749 543
DE-B-1 116 917
US-A-4 181 389

(73) Titulaire: **Eta SA Fabriques d'Ebauches, Schild-Rust- Strasse 17, CH- 2540 Granges (CH)**

(72) Inventeur: **Morata, Philippe, Crêt du Haut 14, CH-2502 Bienne (CH)**

(74) Mandataire: **Gresset, Jean, ICB Ingénieurs Conseils en Brevets SA Passage Max. Meuron 6, CH- 2001 Neuchâtel (CH)**

## Description

La présente invention concerne un module de montre électronique reliant électriquement la pile au circuit de la montre. Elle concerne plus particulièrement un module permettant d'adapter la polarité des électrodes de la pile à la polarité des bornes d'alimentation du circuit.

Les piles utilisées dans les montres électroniques sont toutes semblables extérieurement. Elles sont formées d'un bac métallique de forme cylindrique et d'un couvercle, également métallique, qui ferme le bac de façon étanche, le bac et le couvercle étant par ailleurs isolés électriquement l'un de l'autre. Suivant la capacité énergétique de la pile, ses dimensions sont plus ou moins grandes, mais sa forme générale reste la même.

Jusqu'à récemment, seules les piles au mercure et à l'argent étaient utilisées indifféremment dans les montres, le bac constituant dans ces piles toujours l'électrode positive et le couvercle l'électrode négative.

La pile prend place dans la montre à l'intérieur d'un logement prévu à cet effet dans la platine. Le logement, qui est pourvu de deux bornes venant en contact avec les électrodes, à une dimension lui permettant de recevoir une pile de capacité correspondant à la consommation du circuit. Les bornes, dont une peut avoir par exemple la forme d'une bride, sont reliées au circuit de la montre pour l'alimenter en tension avec une polarité déterminée.

Afin de permettre l'utilisation dans une même montre ou un même calibre de piles de capacités différentes, il est connu de modifier les dimensions du logement, par exemple à l'aide de cales amovibles.

La forme cylindrique de la pile permet, par ailleurs, de l'introduire dans le logement de deux manières différentes, le couvercle de la pile placé en haut ou en bas. Pour que le circuit soit alimenté avec la bonne polarité quelle que soit la position de la pile dans le logement, il est également connu d'utiliser des bornes de forme particulière. Bien entendu la polarité de la pile doit être bien définie.

Or, depuis peu de temps sont apparues sur le marché des piles au lithium présentant l'avantage sur les piles conventionnelles d'avoir une très faible auto-décharge et de ne présenter aucun risque de fuite de l'électrolyte. Si ces nouvelles piles sont compatibles, du point de vue de la tension, de la capacité et des dimensions, avec les exigences requises pour les piles de montre, par contre, la polarité de leurs électrodes est inverse de celles des piles au mercure ou à l'argent. En effet, le bac d'une pile au lithium constitue l'électrode négative et le couvercle l'électrode positive.

Il en résulte qu'une pile conventionnelle au mercure ou à l'argent ne peut être remplacée par une pile au lithium et inversement dans les montres connues. Ceci représente un inconvénient important car il limite les possibilités de choix parmi les piles actuellement existantes.

Pour rendre l'utilisation de ces différentes piles possible, la montre doit comporter un dispositif permettant d'adapter la polarité de la pile à celle du circuit.

Dans les appareils industriels, il est connu d'utiliser des dispositifs de commutation permettant de modifier à volonté des liaisons entre des conducteurs. Par exemple, la demande de brevet EP-A-0 019 836 décrit un commutateur pour signaux haute fréquence formé d'une première plaque, comportant sur une face un premier conducteur et trois autres conducteurs et d'une deuxième plaque comportant un deuxième conducteur, la deuxième plaque pouvant être placée sur la première de manière que le deuxième conducteur relie le premier à l'un des trois autres. Il s'agit donc d'un commutateur unipolaire à trois positions, des vis permettant de fixer la deuxième plaque dans la position voulue.

Des dispositifs de commutation destinés à adapter la tension d'un appareil à celle du réseau sont également connus. Par exemple, les documents DE-B-1 116 917 et DE-A-1 945 678 décrivent de tels commutateurs qui comportent, à cet effet, une plaque isolante pourvue de plages conductrices venant toucher des contacts, la position de la plaque déterminant la tension dont la valeur peut être indiquée par une inscription. Enfin, on peut encore citer le dispositif de commutation utilisé dans un disjoncteur de courant triphasé, décrit dans le brevet US-A-4 181 389, ce dispositif comportant également une plaque avec des plages conductrices, la position de la plaque déterminant dans ce cas l'intensité du courant de coupure dans le disjoncteur. Tous ces dispositifs fonctionnent avec des courants alternatifs. Ils ne sont donc pas destinés à modifier la polarité d'une paire de conducteurs puisque la polarité d'un conducteur ne peut être définie que s'il est parcouru par un courant continu. D'autre part, ces dispositifs sont volumineux et leur construction se prête mal à la miniaturisation requise pour une utilisation horlogère.

Quant au document EP-A1-0 024 364, il enseigne de connecter par un circuit imprimé différents éléments de la montre au circuit intégré et aux pôles de la pile. Ce circuit imprimé comporte des bandes conductrices et est vissé dans le fond de la boîte de montre, constituant ainsi un dispositif de maintien d'une pile dans une montre qui s'adapte à des piles de hauteur différente mais de polarité donnée pour la relier galvaniquement au circuit.

La présente invention à pour but de présenter un module de montre électronique permettant de relier les bornes de la pile aux bornes du circuit avec la polarité voulue, quelque soit le type de pile utilisé. Ce module, comprenant une carte de circuit imprimé comportant un premier jeu de plages conductrices et un deuxième jeu de plages conductrices destinées à être reliées ensemble pour former au moins un trajet de conduction fermé à l'aide d'une plaquette de connexion agencée pour être rapportée à plat sur la carte, sélectivement dans deux positions de connexion particulières, est particulièrement remarquable en ce que:

- les plages du premier jeu sont connectées respectivement aux bornes d'une pile destinée à alimenter le circuit de la montre, tandis que les plages du deuxième jeu sont reliées respectivement à des bornes d'alimentation du circuit de cette montre; et en ce que

- la plaquette comporte un troisième jeu de plages conductrices agencées sur cette plaquette pour réaliser avec les plages de la carte, la fonction d'un inverseur bipolaire à deux positions permettant de relier les bornes de la pile aux bornes d'alimentation, avec une polarité dépendant de la position particulière de la plaquette, les contacts fixes étant constitués par les plages du premier et du deuxième jeu, et les contacts mobiles par les plages du troisième jeu.

D'autres propriétés et avantages de formes d'exécution de l'invention ressortiront de la description qui va suivre, faite en regard des dessins annexés et donnant, à titre explicatif mais nullement limitatif, un exemple de réalisation d'un tel module. Sur ces dessins, où les mêmes références se rapportent à des éléments analogues:

- la figure 1A représente, dans une vue partielle en plan, la face du premier circuit imprimé du module selon l'invention sur laquelle se trouvent les plages conductrices et, en pointillé, une première configuration des liaisons entre ces plages;

- la figure 1B est identique à la figure 1A à l'exception qu'en pointillé est représentée une seconde configuration des liaisons électriques entre les plages;

- la figure 2A est une vue en place du second circuit imprimé montrant les plages conductrices d'une face;

- la figure 2B montre les plages conductrices de l'autre face du circuit représenté sur la fig. 2A; et

- la figure 3 montre un exemple de réalisation du module selon l'invention dans une montre utilisant un circuit souple.

Le module de montre électronique selon l'invention comprend deux circuits imprimés coopérant ensemble. Le premier circuit, référencé 1, est représenté en plan sur la figure 1A. Il comporte une première plage conductrice 2 de forme rectangulaire allongée et une deuxième plage conductrice 3, de même forme que la première, ces deux plages étant disposées symétriquement par rapport à un axe aa' parallèle aux grands côtés des plages. La plage 2 est prolongée dans le sens de sa longueur par une piste conductrice 4 se terminant par un contact 5. De façon analogue, la plage 3 est prolongée par une piste conductrice 6 se terminant par un contact 7. Le circuit 1 porte encore une troisième plage conductrice rectangulaire 8, l'axe longitudinal du rectangle coïncidant avec l'axe aa', et une quatrième plage conductrice 9 de même forme et placée de la même manière par rapport à l'axe aa' que la troisième. La largeur de toutes ces plages est sensiblement la même, alors que la longueur des plages 8 et 9 est inférieure à la moitié de la longueur des plages 2 et 3. Les extrémités extérieures des plages 8 et 9 sont en outre sensiblement alignées sur les extrémités extérieures des plages 2 et 3. Les plages 8 et 9 se trouvent donc disposées symétriquement par rapport à un axe bb' joignant les milieux des grands côtés des plages 2 et 3. Les plages 8 et 9 sont prolongées respectivement par des pistes conductrices 10 et 11 aboutissant à deux bornes d'alimentation d'un circuit électronique non représenté, pouvant avantageusement se trouver sur le premier circuit imprimé 1. Celui-ci porte sur l'axe bb', à égale distance de l'axe aa', deux goupilles de positionnement 12 et 13. Enfin, à l'intersection des axes aa' et bb', est ménagé un trou 14 permettant de recevoir une vis de fixation non représentée.

La figure 1A montre encore qu'une pile 20, à l'argent ou au mercure, est placée dans un logement 21 pratiqué dans la platine 22 de la montre. La pile est formée d'un bac 23, de forme cylindrique, fermé de façon étanche par un couvercle circulaire saillant 24. Le bac 23 constitue l'électrode positive et le couvercle 24 l'électrode négative de la pile. Le logement 21, de forme cylindrique, à un diamètre à sa partie supérieure qui est égal au diamètre du bac 23, alors qu'à sa partie inférieure son diamètre est intermédiaire entre celui du bac 23 et celui du couvercle 24. Au fond du logement 21 est disposée une borne 25 traversant la platine 22. Cette borne, destinée à entrer en contact avec le couvercle de la pile, est isolée de la platine à l'aide d'un manchon isolant 26. La hauteur de la partie du logement 21 à faible diamètre est telle que, lorsque la pile est placée normalement, le bac en haut, son couvercle 24 vient en contact avec la borne 25. Par contre, si la pile est placée le bac en bas, celui-ci ne peut pas toucher la borne. Enfin, une borne 27 en forme de bride, fixée par deux vis non représentées à la platine 22, fait contact avec le bac 23 et maintient fermement la pile 20 dans le logement 21. La borne 25 est donc en contact avec l'électrode négative et la borne 27 avec l'électrode positive de la pile 20 si celle-ci est à l'argent ou au mercure. La tension de la pile est finalement transmise aux plages conductrices 2 et 3 du premier circuit imprimé 1 à l'aide d'un premier conducteur électrique 28, reliant la borne 25 au contact 7, et d'un second conducteur 29, reliant la borne 27 au contact 5.

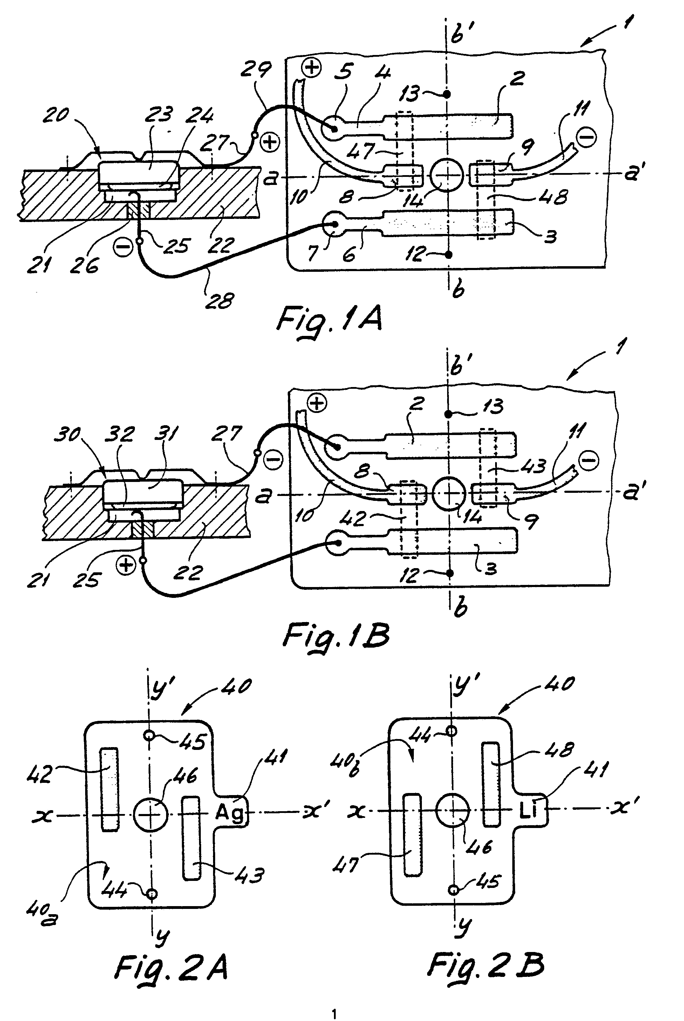

La figure 1B est identique à la figure 1A à l'exception que, dans ce cas, la pile est une pile au lithium 30, de même forme que la pile 20 et ayant sensiblement la même tension. Cette pile est également formée d'un bac 31 et d'un couvercle 32, mais le bac constitue l'électrode négative, alors que le couvercle constitue l'électrode positive. Les bornes 25 et 27 ont donc une polarité inverse de celle indiquée sur la figure 1A.

Le second circuit imprimé 40 du module selon l'invention à deux faces 40a et 40b respectivement représentées sur les figures 2A et 2B. Il à un contour sensiblement rectangulaire avec un axe de symétrie horizontal xx' et un axe de symétrie vertical yy'. La face 40A porte un symbole représentatif du type de pile utilisée, par exemple Ag pour une pile à l'argent, qui est inscrit sur un ergot 41 prolongeant le circuit dans le sens de l'axe xx'. Cette face porte une première plage conductrice 42 de forme rectangulaire et une deuxième plage conductrice 43 de même dimension. Les grands côtés de ces deux plages sont parallèles à l'axe yy' et elles sont placées à égale distance de part et d'autre de cet axe. La plage 42 se trouve principalement dans la partie supérieure du circuit 40, tout en empiétant légèrement sur sa partie inférieure. La longueur de cette plage est légèrement plus grande que la distance séparant les plages 2 et 8 du circuit 1, alors que sa largeur est égale à environ la moitié de la longueur de la plage 8. La plage 43 a une position symétrique de la plage 42 par rapport au point d'intersection des axes xx' et yy' et la distance qui sépare ces deux plages, mesurée le long de l'axe xx', est sensiblement égale à celle existant entre les milieux des plages 8 et 9 du circuit 1. Un trou de positionnement 44 est ménagé sur l'axe yy' du circuit 40 à une distance égale à celle qui sépare la goupille 12 de l'axe aa', le diamètre de ce trou étant le même que celui de la goupille. Un second trou de positionnement 45 se trouve encore sur l'axe yy'. Il à le même diamètre que le trou 44 et occupe une position symétrique de ce dernier par rapport à l'axe xx'. Enfin, un trou 46, de même diamètre que le trou 14, est ménagé sur le circuit 40 à l'intersection des axes xx' et yy'.

La figure 2B montre la face 40b du circuit, dont l'ergot 41 porte l'inscription Li, pour désiquer une pile au lithium. Sur cette face du circuit se trouvent une troisième et une quatrième plages conductrices, référencées respectivement 47 et 48, de mêmes formes et dimensions que les plages 42 et 43. La plage 47 se trouve exactement en face de la plage 42. De même, la plage 48 se trouve en face de la plage 43.

Le circuit 40 coopère avec le circuit 1 de la façon suivante. En supposant que la pile utilisée dans la montre soit une pile à l'argent, ce qui correspond au cas de la figure 1A, le circuit imprimé 40 est placé sur le circuit 1 avec l'inscription Ag apparente, c'est-à-dire dans la position représentée sur la figure 2A, de manière que la goupille 12 s'engage dans le trou 44 et la goupille 13 dans le trou 45. Dans cette position, c'est donc la face 40b qui prend place sur le circuit 1. La plage 47 vient alors se placer sur les plages 2 et 8, et la plage 48 sur les plages 3 et 9, ainsi que cela est indiqué en pointillé sur la figure 1A. Le bon contact entre les plages et le maintien des circuits est assuré par une vis de fixation non représentée, passant par les trous 14 et 46 et serrant les deux circuits l'un contre l'autre. La piste 10 est ainsi reliée à l'électrode positive de la pile 20 et la piste 11 à son électrode négative. On supposera que cette polarité des pistes 10 et 11 correspond à la polarité des bornes d'alimentation du circuit électronique, non représenté, auxquelles elles sont connectées.

Si maintenant la pile à l'argent 20 est remplacée par une pile au lithium 30 de polarité inverse, pour que la piste 10 reste reliée à l'électrode positive de la pile et la piste 11 à l'électrode négative, il suffit de retourner le circuit imprimé 40 autour de l'axe xx'. Dans cette position, correspondant à celle de la figure 2B, où l'inscription Li est apparente, c'est la face 40a qui prend place sur le circuit 1. La plage 42 vient se placer sur les plages 3 et 8, alors que la plage 43 vient se placer sur les plages 2 et 9, ainsi que cela est montré en pointillé sur la figure 1B.

Bien entendu le module qui vient d'être décrit peut subir différentes modifications et se présenter sous d'autres variantes évidentes pour l'homme de l'art, sans sortir du cadre de la présente invention.

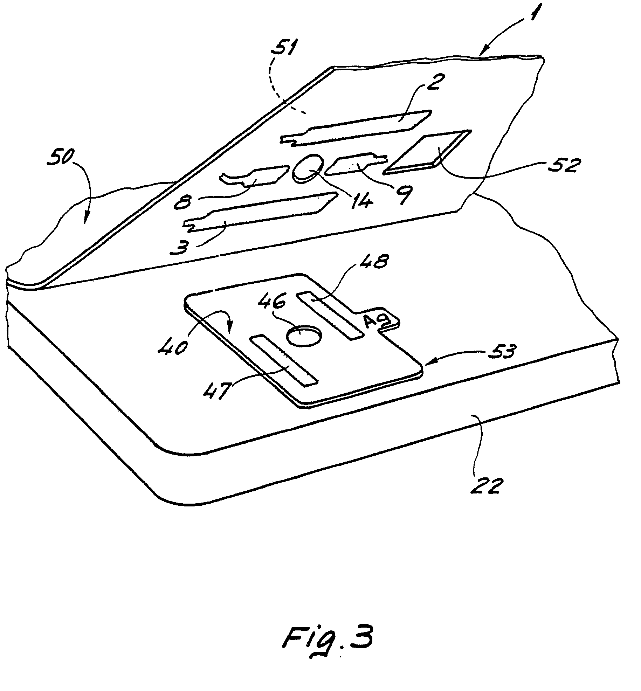

Par exemple la fig. 3 montre, dans une vue en perspective, une autre forme de réalisation du module selon l'invention. Prenant peu de place, cette exécution est particulièrement bien adaptée aux applications horlogères de petit volume. On distingue sur cette figure la platine 22 d'une montre qui porte, fixé sur une de ses faces, un circuit imprimé souple 50 sur lequel peuvent avantageusement prendre place, par exemple, un circuit intégré et divers composants non représentés. Le circuit 50 n'est pas entièrement fixé sur la platine 22, mais son extrémité 51 peut être soulevée, ainsi que cela apparaît sur la fig. 3. Cette extrémité constitue un circuit imprimé identique au premier circuit imprimé 1 déjà décrit. Sa face en regard de la platine 22 porte les plages conductrices 2, 3, 8 et 9 déjà mentionnées. Dans cette extrémité sont, en outre, pratiqués le trou 14 et une ouverture 52. Dans l'épaisseur de la platine 2, sous les plages conductrices du circuit imprimé 51, est ménagé un logement 53 destiné à recevoir le circuit imprimé 40, représenté dans la position correspondant à l'utilisation d'une pile à l'argent ou au mercure, avec le symbole Ag apparent. Le contour du logement 53 correspond exactement à celui du circuit 40, ce qui rend superflue l'utilisation des goupilles 12, 13 et des trous 44, 45. Par contre, dans ce circuit est pratiqué le trou de positionnement 46 qui se prolonge par un pas de vis dans la platine 22.

Dans cette forme de réalisation, c'est la face du circuit portant le symbole Ag qui vient contre les plages 2, 3, 8 et 9. C'est sur cette face que se trouvent donc les plages conductrices 47 et 48, disposées pour entrer en contact respectivement avec les plages 2, 8 et 3, 9. Bien entendu, l'autre face du circuit 40 porte le symbole Li et les plages 42 et 43, non visibles, destinées à entrer en contact respectivement avec les pistes 3, 8 et 2, 9. Le circuit 40 étant mis en place dans son logement dans la position correspondant au type de pile choisi, l'extrémité 51 du film souple 50 peut être rabattue contre la platine 22, laissant apparaître le symbole de la pile à travers l'ouverture 52. Les plages conductrices des deux circuits imprimés entrent alors en contact, établissant les liaisons électriques voulues. Les deux circuits sont fermement maintenus l'un contre l'autre à l'aide d'une vis non représentée fixée dans la platine 22 au travers des trous 14 et 46.

## Revendications

1. Module de montre électronique comprenant une carte de circuit imprimé (1) comportant un premier jeu de plages conductrices (2, 3) et un deuxième jeu de plages conductrices (8, 9) destinées à être reliées ensemble pour former au moins un trajet de conduction fermé à l'aide d'une plaquette de connexion (40) agencée pour être rapportée à plat sur la carte, sélectivement dans deux positions de connexion particulières, caractérisé en ce que:
   - les plages (2, 3) dudit premier jeu sont connectées respectivement aux bornes d'une pile (20) destinée à alimenter ledit circuit, tandis que les plages (8, 9) dudit deuxième jeu sont reliées respectivement à des bornes d'alimentation dudit circuit; et en ce que
   - ladite plaquette (40) comporte un troisième jeu de plages conductrices (42, 43, 47, 48) agencées sur cette plaquette pour réaliser, avec les plages de ladite carte, la fonction d'un inverseur bipolaire à deux positions permettant de relier les bornes de la pile auxdites bornes d'alimentation avec une polarité dépendant de la position particulière de la plaquette, les contacts fixes étant constitués par les plages du premier et du deuxième jeu, et les contacts mobiles par les plages du troisième jeu.

2. Module selon la revendication 1, caractérisé en ce que ladite plaquette (40) comporte une première face (40a) et une deuxième face (40b), et en ce que ledit troisième jeu de plages comprend deux paires de plages (42, 43; 47, 48), chaque paire étant disposée sur une face de la plaquette, le retournement de celle-ci permettant de passer d'une position particulière à l'autre.

3. Module selon la revendication 2, caractérisé en ce que la plaquette (40) comporte sur chaque face (40a, 40b) une indication (Ag, Li) rappelant le type de pile susceptible de fournir auxdites bornes d'alimentation une tension de polarité voulue.

4. Module selon la revendivation 2 ou 3, caractérisé en ce que:
   - la carte de circuit imprimé (1) comporte, disposées symétriquement par rapport à un axe (aa'), une première (2) et une deuxième (3) plage conductrice formant ledit premier jeu, et, sur cet axe, entre les plages du premier jeu, une troisième (8) et une quatrième (9) plage conductrice formant ledit deuxième jeu; et en ce que
   - la plaquette de connexion (40) comporte, de son côté, sur une face (40a), deux plages conductrices (42, 43) placées de part et d'autre d'un axe (xx') de cette face, la distance entre ces deux plages, mesurée le long de cette axe (xx'), étant sensiblement égale à celle séparant la troisième (8) de la quatrième (9) plage, mesurée le long de l'axe (aa') de la carte, et, sur l'autre face (40b) de la plaquette, deux autres plages conductrices (47, 48) placées respectivement en regard des deux plages (42, 43) de la face précédente, les plages de ces deux faces formant ledit troisième jeu, une desdites positions de la plaquette correspondant à l'application d'une face (40a) de cette plaquette sur la carte en faisant coïncider lesdits axes (aa', xx'), les plages (42, 43) de cette face venant relier respectivement la deuxième (3) à la troisième (8) plage et la première (2) à la quatrième (9) plage, l'autre position de la plaquette s'obtenant en appliquant l'autre face (40b) sur la carte en faisant coïncider lesdits axes (aa', xx'), les plages (47, 48) de cette dernière face venant relier respectivement la première (2) à la troisième (8) plage, et la deuxième (3) à la quatrième (9) plage.

## Patentansprüche

1. Elektrischer Uhren-Modul, umfassend eine gedruckte Schaltungskarte (1), die einen ersten Satz Leiterbahnen (2, 3) und einen zweiten Satz Leiterbahnen (8, 9) aufweist, welche miteinander verbunden werden, um mindestens einen geschlossenen Leiterkreis zu bilden, und zwar mittels einer Verbindungsplatte (40), die so ausgelegt ist, dass sie wahlweise in zwei besonderen Verbindungslagen flach auf der Schaltungskarte angeordnet werden kann, dadurch gekennzeichnet, dass:
   - die Bahnen (2, 3) des genannten ersten Satzes jeweils mit den Klemmen einer Batterie (20) verbunden sind, die die genannte Schaltung speisen, während die Bahnen (8, 9) des genannten zweiten Satzes jeweils an Speiseklemmen der genannten Schaltung angeschlossen sind; und dadurch, dass
   - die genannte Platte (40) einen dritten Satz Leiterbahnen (42, 43, 47, 48) aufweist, die so angeordnet sind, dass sie mit den Bahnen der genannten Karte die Funktion eines zweipoligen Umschalter mit zwei Stellungen bilden, über den die Klemmen der Batterie mit den genannten Speiseklemmen verbunden werden können, wobei die Polarität von der besonderen Lage der Platte abhängt und die festen Kontakte von den Bahnen des ersten und des zweiten Satzes und die beweglichen Kontakte von den Bahnen des dritten Satzes gebildet werden.

2. Modul gemäss Anspruch 1, dadurch gekennzeichnet, dass die genannte Platte (40) eine erste Seite (40a) und eine zweite Seite (40b) umfasst, und dadurch, dass der genannte dritte Bahnensatz zwei Bahnpaare (42, 43; 47, 48) umfasst, wobei jedes Paar jeweils auf einer Seite der Platte angeordnet ist und wobei deren Umkehrung es gestattet, von einer besonderen Lage zur anderen zu wechseln.

3. Modul gemäss Anspruch 2, dadurch gekennzeichnet, dass die Platte (40) auf jeder Seite (40a, 40b) eine Kennzeichnung (Ag, Li) aufweist, die den Typ der Batterie angibt, die den genannten Speiseklemmen eine Spannung der gewünschten Polarität liefert.

4. Modul gemäss den Ansprüchen 2 oder 3, dadurch gekennzeichnet, dass:

- die gedruckte Schaltungskarte (1) eine erste (2) und eine zweite (3) symmetrisch zu einer Achse (aa') angeordnete Leiterbahn umfasst, die den genannten ersten Satz bilden, sowie, auf dieser Achse und zwischen den Bahnen des ersten Satzes, eine dritte (8) und eine vierte (9) Leiterbahn, die den genannten zweiten Satz bilden; und dadurch, dass

- die Verbindungsplatte (40) ihrerseits auf einer Seite (40a) zwei Leiterbahnen (42, 43) umfasst, die beiderseits einer Achse (xx') dieser Seite verlaufen, wobei der Abstand zwischen diesen beiden Bahnen, gemessen längs dieser Achse (xx'), gleich jenem zwischen der dritten (8) und der vierten (9) Bahn ist, gemessen längs der Achse (aa') der Karte, und, auf der anderen Seite (40b) der Platte, zwei weitere Leiterbahnen (47, 48), die jeweils gegenüber den beiden Bahnen (42, 43) der vorhergenannten Seite angeordnet sind, wobei die Bahnen dieser beiden Seiten den genannten dritten Satz bilden und eine der genannten Lagen der Platte dem Aufsetzen einer Seite (40a) dieser Platte auf die Karte entspricht, wenn die genannten Achsen (aa', xx') sich decken, wobei die Bahnen (42, 43) dieser Seite jeweils die zweite (3) mit der dritten (8) Bahn und die erste (2) mit der vierten (9) Bahn verbinden, während die andere Lage der Platte gegeben ist, wenn man die andere Seite (40b) auf die Karte auflegt und die genannten Achsen (aa', xx') sich decken, wobei die Bahnen (47, 48) dieser anderen Seite jeweils die erste (2) mit der dritten (8) Bahn und die zweite (3) mit der vierten (9) Bahn verbinden.

## Claims

1. An electronic watch module comprising a printed circuit card (1) having a first set of conductive areas (2, 3) and a second set of conductive areas (8, 9) intended to be connected together to form at least one conduction path that is closed by means of a connector plate (40) arranged to be applied flat on the card, selectively in either of two particular connection positions, characterized in that:

- the conductive areas (2, 3) of said first set are respectively connected to the terminals of a cell (20) for supplying said circuit, while the conductive areas (8, 9) of said second set are respectively connected to supply terminals of said circuit; and in that

- said plate (40) has a third set of conductive areas (42, 43, 47, 48) arranged on the plate to perform, with the conductive areas of said card, the function of a two-position bipolar inverter enabling the terminals of the cell to be connected to said supply terminals with a polarity that depends on the particular position of the plate, the stationary contacts being formed by the conductive areas of the first and second sets and the movable contacts being formed by the conductive areas of the third set.

2. A module according to claim 1, characterized in that said plate (40) has a first surface (40a) and a second surface (40b), and in that said third set of conductive areas comprises two pairs of conductive areas (42, 43; 47, 48), each pair being disposed on one surface of the plate, the turning over of the latter making it possible to change from one particular position to the other.

3. A module according to claim 2, characterized in that the plate (40) has on each surface (40a, 40b) an indication (Ag, Li) denoting the type of cell capable of supplying to said supply terminals a voltage of required polarity.

4. A module according to claim 2 or 3, characterized in that:

- the printed circuit card (1) has first (2) and second (3) conductive areas symmetrically arranged in relation to an axis (aa') that form said first set and, on said axis and between the conductive areas of the first set, third (8) and fourth (9) conductive areas that form said second set; and in that

- the connector plate (40) has, on one surface (40a), two conductive areas (42, 43) placed on opposite sides of an axis (xx') of this surface, the distance between these two conductive areas, measured along this axis (xx'), being substantially equal to that between the third (3) and fourth (9) conductive areas, measured along the card's axis (aa'), and, on the other surface (40b) of the plate, two more conductive areas (47, 48) respectively placed in facing relationship with the two conductive areas (42, 43) of the preceding surface, the conductive areas of these two surfaces forming said third set, one of the plate's said positions corresponding to the application of one surface (40a) thereof to the card with said axes (aa', xx') being made to coincide, the conductive areas (42, 43) of this surface respectively connecting the second conductive area (3) to the third (8) and the first conductive area (2) to the fourth (9), the other position of the plate being obtained by applying the other surface (40b) to the card with said axes (aa', xx') being made to coincide, the conductive areas (47, 48) of the latter surface respectively connecting the first conductive area (2) to the third (8) and the second conductive area (3) to the fourth (9).

Fig. 1A

Fig.1B

Fig. 2A

Fig. 2 B

Fig.3